# EUROPEAN PATENT SPECIFICATION

(11) **EP 3 103 133 B1**
(45) Date of publication and mention of the grant of the patent: **26.08.2026**
(21) Application number: 15746578.2
(22) Date of filing: 06.02.2015
(51) Int. Cl.: H10P 52/40, C09G 1/02, C09K 3/14

(54) **CMP METHOD FOR SUPPRESSION OF TITANIUM NITRIDE REMOVAL**
CMP-VERFAHREN ZUR UNTERDRÜCKUNG VON TITANNITRIDENTFERNUNG
PROCÉDÉ CMP POUR SUPPRESSION DU RETRAIT DE NITRURE DE TITANE

(30) Priority: 05.02.2014 US 201461936009 P
(43) Date of publication of application: 14.12.2016
(73) Proprietor: CMC Materials LLC, Wilmington, DE 19801 (US)
(72) Inventor: HOU, Hui-Fang, Aurora, Illinois 60504 (US); WARD, William, Aurora, Illinois 60504 (US); YEH, Ming-Chih, Aurora, Illinois 60504 (US); TSAI, Chih-Pin, Aurora, Illinois 60504 (US)
(74) Representative: Barker Brettell LLP
(86) International application number: PCT/US2015/014815
(87) International publication number: WO 2015/120269

(56) References cited:
- EP-A1- 1 568 746
- EP-A1- 2 123 726
- EP-A1- 2 818 526
- EP-A2- 1 732 999
- EP-A2- 1 813 658
- JP-A- 2009 064 881
- US-A1- 2003 079 416
- US-A1- 2007 075 042
- US-A1- 2007 293 049
- US-A1- 2008 026 525
- US-A1- 2009 209 103
- US-A1- 2011 081 780
- US-A1- 2011 186 542
- US-A1- 2011 247 996
- US-A1- 2012 094 489
- US-B1- 6 258 140

## Description

### FIELD OF THE INVENTION

This invention relates to chemical mechanical polishing (CMP) methods. More particularly, this invention relates to CMP methods for suppressing removal of a titanium nitride barrier layer.

### BACKGROUND

In manufacturing of advanced semiconductor devices (both memory and logic) certain integration schemes require a selective removal of a metals (e.g., Cu, CuMn, Ta, TaN, Al, AlCo, Co, CoMo, Ru, RuTa, RuTiN, Mn, TiN (Self-stop), W, Pt) or dielectrics (e.g., silicon oxide, silicon nitride, silicon carbide, polysilicon) or polymers (e.g., PR, SOG type oxide) with cessation of removal upon reaching a barrier layer (commonly referred to as "stop on barrier"). Compositions and methods for chemical mechanical polishing (CMP) of the surface of a substrate are well known in the art. Polishing compositions (also known as polishing slurries, CMP slurries, and CMP compositions) for CMP of surfaces of semiconductor substrates (e.g., for integrated circuit manufacture) typically contain an abrasive, various additive compounds, and the like. In the case of barrier layers formed from titanium nitride (TiN) and titanium/titanium nitride (Ti/TiN), the stop on barrier process can be difficult, since typical CMP compositions are not particularly selective for removal of the overlying metal layer relative to the TiN or Ti/TiN layer.

One particular application of the stop on barrier technique is in tungsten (W) gate formation, which involves CMP removal of a W layer disposed on a barrier layer over an oxide substrate. A depression in oxide substrate is lined with a portion of the barrier layer and filled with the W metal. During polishing, the W layer is removed by CMP down to a planar portion of the barrier layer. A portion of W within depression then is removed by etching to form a gate structure. One major difficulty in the stop on barrier technique is undesired removal of the planar portion of the barrier layer, which can lead to a lower gate height or other problems. Often, CMP compositions are not selective enough to reliably and consistently stop material removal when the barrier layer is exposed.

In view of the difficulties encountered in metal removal over a TiN barrier, there is an ongoing need for CMP compositions and methods that achieve effective metal removal while suppressing TiN barrier removal. The methods described herein address this need.

Each one of EP 1 732 999 A2, US 2003/079416 A1, EP 1 568 746 A1, US 2009/209103 A1, JP 2009 064881 A, EP 1 813 658 A2, EP 2 123 726 A1, US 2007/075042 A1, and US 2011/081780 A1 relates to a chemical mechanical polishing (CMP) method of polishing a substrate comprising a metal deposited over a barrier layer.

### BRIEF SUMMARY OF THE INVENTION

The invention relates to a chemical mechanical polishing (CMP) method for removing a metal layer deposited over a TiN barrier layer as defined in claim 1, with dependent claims defining additional features. The method comprises abrading away the metals (e.g., Cu, CuMn, Ta, TaN, Al, AlCo, Co, CoMo, Ru, RuTa, RuTiN, Mn, W, Pt) with an acidic CMP composition (e.g., in conjunction with a polishing pad in a CMP polishing apparatus). The method is particularly useful for stop-on-barrier polishing of substrates comprising a TiN barrier layer. The surfactant surprisingly aids in suppression of TiN removal while not interfering with metals removal.

In some embodiments the CMP composition comprises 0.001 to 10 percent by weight (wt%) of the particulate abrasive. According to the invention, the particulate abrasive includes colloidal silica with a mean particle size of 10 to 150 nm, and the pH of the CMP composition is in the range of 2 to 5. The surfactant can be present in the CMP composition, e.g., at a concentration in the range of 10 to 50,000 parts-per-million (ppm).

According to the invention, the CMP composition further comprises hydrogen peroxide in a range of 0.01 to 5 wt%.

According to the invention, the surfactant comprises a mixture of C10-C14 alkylbenzene sulfonate and ethoxylated C6-C12 alcohols.

The methods described herein advantageously provide excellent selectivity for metal removal relative to TiN. In particular, anionic and nonionic surfactants surprisingly aid in suppression of TiN removal while still allowing for acceptable metal removal rates.

### BRIEF DESCRIPTION OF THE DRAWINGS

FIG. 1 provides graphs of TiN removal rate (RR) suppression (%) observed upon polishing of TiN blanket wafers with CMP compositions comprising various anionic and nonionic surfactants.
FIG. 2 provides graphs of the TiN removal rates for CMP compositions having a pH of 2.3 and comprising 0.025 percent by weight (wt%) of colloidal silica, 750 ppm of ferric ion chelated with 0.162 wt% of malonic acid, and 1000 ppm (actives concentration) of various surfactants.
FIG. 3 provides graphs of TiN RR and TiN RR suppression (%) observed upon polishing of TiN blanket wafers with CMP compositions comprising colloidal silica with (w/) and without (w/o) 1000 ppm of dodecylbenzene sulfonic acid surfactant at various silica solids content concentrations (SC%).
FIG. 4 provides graphs of TiN RR and TiN RR suppression (%) observed upon polishing of TiN blanket wafers with CMP compositions comprising 0.025 wt% colloidal silica with (w/) and without (w/o) 1000 ppm of dodecylbenzene sulfonic acid surfactant at various composition pH values.
FIG. 5 provides graphs of TiN RR and TiN RR suppression (%) observed upon polishing of TiN blanket wafers with CMP compositions comprising 0.025 wt% of various abrasives with (w/) and without (w/o) 1000 ppm of dodecylbenzene sulfonic acid surfactant.

### DETAILED DESCRIPTION OF THE INVENTION

The CMP compositions useful in the methods described herein include a particulate abrasive and a surfactant in an aqueous carrier. The compositions surprisingly result in suppressing TiN removal rate while still providing an acceptable rate of removal for metal (e.g., Cu, CuMn, Ta, TaN, Al, AlCo, Co, CoMo, Ru, RuTa, RuTiN, Mn, W, Pt).

According to the invention, the surfactant component of the CMP composition comprises a mixture of C10-C14 alkylbenzene sulfonate and ethoxylated C6-C12 alcohols. The surfactant may be in the composition at a concentration of at least 10 ppm, for example, at least 25 ppm, at least 50 ppm, at least 100 ppm, at least 500 ppm, at least 1000 ppm, or at least 2,000 ppm. Additionally, the surfactant may be in the composition at a concentration of no more than 50,000 ppm, for example, 40,000 ppm, 30,000 ppm, 20,000 ppm, 10,000 ppm or 5,000 ppm. Typically, the surfactant is present in the CMP composition at a concentration in the range of 10 to 50,000 ppm, preferably 50 to 5000 ppm.

As will be readily understood by those of ordinary skill in the chemical arts, the surfactant in a given CMP composition generally will be selected to be stable at the storage pH of the CMP composition. The particulate abrasive comprises colloidal silica and has an average particle size (i.e., average particle diameter) of 10 to 150 nm. The abrasive can have an average particle size of 15 nm or more, 20 nm or more, or 25 nm or more. In addition, the abrasive can have an average particle size of 120 nm or less, 110 nm or less, 100 nm or less, 90 nm or less, 80 nm or less, 70 nm or less, 60 nm or less, 50 nm or less, or 40 nm or less. Thus, the abrasive can have an average particle size bounded by any two of the above endpoints. For a non-spherical particle, the size of the particle is the diameter of the smallest sphere that encompasses the particle. The silica particles can be generally spherical, oblate spherical, dumb bell shaped, or cocoon.

The polishing composition can contain 0.001 wt.% or more, 0.1 wt.% or more, 0.25 wt.% or more, or 0.5 wt.% or more of abrasive. Alternatively, or in addition, the polishing composition can contain 10 wt.% or less, 5 wt.% or less, 4 wt.% or less, 3 wt.% or less, or 2 wt.% or less of abrasive. Thus, the polishing composition can comprise abrasive in an amount bounded by any two of the above endpoints recited for the abrasive. The abrasive typically is present in the CMP composition at a concentration in the range of 0.001 to 10 wt%, preferably 0.001 to 5 wt%. Preferably, the abrasive is present in the CMP composition at a concentration of 0.001 to 10 wt% (e.g., 0.001 to 5 wt%). At point of use during a polishing method as described herein the abrasive preferably is present in the CMP composition at a concentration of 0.001 to 5 wt% (e.g., 0.001 to 2 wt%).

Desirably, the silica abrasive will have a zeta potential of greater than 0 mV at pH of 2.3, in the polishing composition. The zeta potential of a particle refers to the difference between the electrical charge of the ions surrounding the particle and the electrical charge of the bulk solution (e.g., the liquid carrier and any other components dissolved therein).

The compositions used in the method of the present invention have an acidic pH. According to the invention, the pH is in the range of 2 to 5. The pH of the composition can be achieved and/or maintained by inclusion of a buffering material including an acidic component, which can comprise any inorganic or organic acid. Preferably, the acidic pH is maintained by an organic or inorganic buffer comprising basic and acidic components in amounts and ratios suitable to achieve the desired pH. Acidic buffers are well known to those of ordinary skill in the chemical arts.

The CMP composition further comprises an oxidizing agent. According to the invention, the CMP composition further comprises hydrogen peroxide in a range of 0.01 to 5wt%, optionally in combination with a metal ion (e.g., ferric ion). The polishing composition can contain any suitable amount of oxidizing agent. The polishing composition can contain 0.05 wt.% or more, 0.1 wt.% or more, or 0.25 wt.% or more of oxidizing agent. In addition, the polishing composition can contain 2.5 wt.% or less, 1 wt.% or less, 0.8 wt.% or less, or 0.6 wt.% or less of oxidizing agent. Thus, the polishing composition can comprise the oxidizing agent in an amount bounded by any two of the above endpoints recited for the oxidizing agent.

In conventional CMP techniques, a substrate carrier or polishing head is mounted on a carrier assembly and positioned in contact with a polishing pad in a CMP apparatus. The carrier assembly provides a controllable pressure to the substrate, urging the substrate against the polishing pad. The pad and carrier, with its attached substrate, are moved relative to one another. The relative movement of the pad and substrate serves to abrade the surface of the substrate to remove a portion of the material from the substrate surface, thereby polishing the substrate. The polishing of the substrate surface typically is further aided by the chemical activity of the polishing composition (e.g., by oxidizing agents, acids, bases, or other additives present in the CMP composition) and/or the mechanical activity of a particulate abrasive suspended in the polishing composition.

The polishing compositions optionally also can include suitable amounts of one or more other additive materials commonly included in polishing compositions, such as metal complexing agents, dispersants, stabilizers, corrosion inhibitors, viscosity modifying agents, biocides, cationic surfactants, nonionic surfactants, inorganic salts, and the like. For example, the composition can include a biocide such as KATHON^{®} or NEOLONE^{®} biocides; a complexing agent such as acetic acid, histidine, lysine, glycine, picolinic acid, tartaric acid, iminodiacetic acid, alanine, benzoic acid, nitrilotriacetic acid (NTA), glutamic acid, glutaric acid, beta-alanine, aspartic acid, ornithine, or proline; a corrosion inhibitor such as benzotriazole (BTA), 1,2,3-triazole, 1,2,4-triazole, a tetrazole (i.e. 5-aminotetrazole), 3-amino-1,2,4-triazole, phenylphosphonic acid, methylphosphonic acid; and the like. In some embodiments, the CMP composition can include a water soluble salt, e.g., ammonium nitrate for profile control and conductivity. For example, the composition can include 50 to 2000 ppm of the water soluble salt. The CMP composition also can include a cationic surfactant that can selectively bind to silicon oxide relative to silicon nitride to further aid in silicon nitride removal selectivity.

The aqueous carrier can be any aqueous solvent, e.g., water, aqueous methanol, aqueous ethanol, a combination thereof, and the like. Preferably, the aqueous carrier comprises, consists essentially of, or consists of water, more preferably deionized water.

The polishing compositions used in the methods described herein can be prepared by any suitable technique, many of which are known to those skilled in the art. The polishing composition can be prepared in a batch or continuous process. Generally, the polishing composition can be prepared by combining the components thereof in any order. The term "component" as used herein includes individual ingredients (e.g., abrasive, polymer, chelating agents, buffers, and the like), as well as any combination of ingredients. Typically, the oxidizing agent is not added to the polishing composition until the composition is ready for use in a CMP process, for example, the oxidizing agent can be added just prior to initiation of polishing. The pH can be further adjusted at any suitable time by addition of an acid or base, as needed.

The polishing compositions also can be provided as a concentrate, which is intended to be diluted with an appropriate amount of aqueous solvent (e.g., water) prior to use. In such an embodiment, the polishing composition concentrate can include the various components dispersed or dissolved in aqueous solvent in amounts such that, upon dilution of the concentrate with an appropriate amount of aqueous solvent, each component of the polishing composition will be present in the polishing composition in an amount within the appropriate range for use.

The CMP methods of the invention preferably are achieved using a chemical-mechanical polishing apparatus. Typically, the CMP apparatus comprises a platen, which, when in use, is in motion and has a velocity that results from orbital, linear, and/or circular motion, a polishing pad in contact with the platen and moving relative to the platen when in motion, and a carrier that holds a substrate to be polished by contacting and moving relative to the surface of the polishing pad. The polishing of the substrate takes place by the substrate being placed in contact with the polishing pad and a polishing composition and then moving the polishing pad relative to the substrate, so as to abrade at least a portion of the substrate to polish the substrate.

The following examples further illustrate certain aspects of the invention. As used herein and in the following examples and claims, concentrations reported as parts-per-million (ppm) or percent by weight (wt%) are based on the weight of the active component of interest divided by the weight of the composition.

The following non-limiting examples are provided to further illustrate certain aspects and features of the compositions and methods described herein.

### EXAMPLE 1

This example illustrates the effect of different surfactants on TiN removal rate suppression.

The acidic composition comprising ZETASPERSE^{®} 2300 (7 in Table 2) as the surfactant is useful in the method of the invention.

The acidic CMP compositions comprising other surfactants (tradenames 1-6, 8-35 in Table 2) are not useful in the method of the invention.

The abrasives used in this, and following examples, are summarized in Table 1.

**Table 1.**

| Abrasive | Abrasive Type | Shape | Zeta Pot. at pH 2.3 | Ave Particle Size |
|---|---|---|---|---|
| A | Alumina | Spherical | -15.1 | 100nm |
| B | Colloidal Silica | Cocoon | 4.83 | 25nm |
| C | Colloidal Silica | Cocoon | 3.82 | 35nm |
| D | Colloidal Silica | Cocoon | 6.4 | 50nm |
| E | Colloidal Silica | Cocoon | 12.1 | 70nm |
| F | Colloidal Silica | Spherical | 1.19 | 50nm |
| G | Colloidal Silica | spherical | 5.1 | 70nm |
| H | Colloidal Silica | Cocoon | 7.35 | 50nm |
| I | Colloidal Silica | Cocoon | 38.4 | 35nm |
| J | Colloidal Silica | Cocoon | 50.9 | 50nm |

Aqueous CMP compositions having a pH of 2.3 and comprising 0.025 percent by weight (wt%) of colloidal silica (Abrasive J from Table 1, Fuso Chemical Co. Ltd.), 0.5 wt% hydrogen peroxide and 1000 ppm (actives concentration) of the various surfactants listed in Table 2, with the balance being water, were prepared. TiN blanket wafers were polished with the various compositions for 60 seconds using a Fujibo H7000 polishing pad and the following polishing parameters: carrier speed of 111 rpm, platen speed of 113 rpm, down force of 1.5 psi and slurry flow rate of 150 mL. The amount of TiN removal observed with each composition was compared to the amount of TiN removal observed upon polishing of a TiN blanket wafer with a comparative CMP composition (control) having the same basic formulation as the test compositions, but without any added surfactant. The TiN removal rate (RR) suppression was calculated by subtracting the removal rate for the test composition from the removal rate for the control and expressing the difference as a percentage of the control.

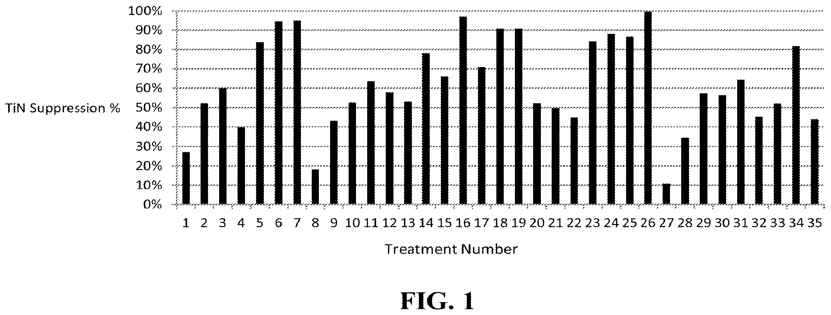

FIG. 1 provides graphs of the observed TiN RR suppression (%) for the various anionic and nonionic surfactants. Evaluations of surfactant inhibitors and various non-surfactant additives (e.g., amino acids and triazoles) indicated that the non-surfactant additives were not suitable for providing the desired suppression of TiN RR. In some instances, particularly for sulfate, sulfonate, phosphate, alkylaryl alcohol, amide, and alkyne diol surfactants, TiN RR suppression of greater than 80% was observed (see e.g., results for SINONATE 1105SF (5), SINONATE 290MH (6), ZETASPERSE 2300 (7), DBS (16), OLFINE WE-001 (18), OLFINE WE-003 (19), SURFYNOL 604 (23), SURFYNOL 707P (24), SINOPOL 9620P (25), poly(acrylamide) (34), and RHODAFAC RS710 (26) in FIG. 1.

**Table 2.**

| Treatment Number | Active Component | Tradename (CAS*) | Type |
|---|---|---|---|
| 1 | (Ammonium P.O.E styrenated aryl ether sulfate) | SINONATE^{®} 707SF (104042-66-2) | anionic |
| 2 | Polyoxyethylene nonylphenyl ether sulfate ammonium salt | SINONATE^{®} 960SF (9051-57-4) | anionic |
| 3 | Polyoxyethylene nonylphenyl ether sulfate ammonium salt | SINONATE^{®} 962SF (9051-57-4) | anionic |
| 4 | Sodium 2-ethylhexyl sulfate | SINONATE^{®} EHS (126-92-1) | anionic |
| 5 | Ammonium lauryl polyoxyethylene ether sulfate | SINONATE^{®} 1105SF (9004-82-4) | anionic |
| 6 | Sodium dialkyl sulfosuccinate | SINONATE^{®} 290MH (36409-57-1) | anionic |
| 7 | Mixture of (C10-C14) alkylbenzene sulfonate and ethoxylated (C6-C12) alcohols | ZETASPERSE ^{®} 2300 | anionic |
| 8 | α-Sulfo-ω-(1-((4-nonylphenoxy) methyl)-2-(2-propenyloxy) ethoxy)-Poly(oxy-1,2-ethanediyl), ammonium salt | RES-10A (403983-53-9) | anionic |
| 9 | Poly(oxy-1, 2-ethanediyl), alpha-sulfo-omega-[1-hydroxymethyl)-2-(2-propenyloxy) ethoxyl]-, C11-rich C10-14-branched alkyl ethers, ammonium salts | ADEKA REASOAP SR-10 (905843-50-7 and 403983-53-9) | anionic |
| 10 | Benzenesulfonic acid, decyl (sulfophenoxy)-, disodium salt | DOWFAX^{®} C6L (147732-60-3) | anionic |
| 11 | Benzenesulfonic acid, decyl (sulfophenoxy)-, disodium salt | DOWFAX^{®} C10L (36445-71-3) | anionic |
| 12 | Benzenesulfonic acid, decyl(sulfophenoxy)-, sodium salt (1:2)] | DOWFAX^{®} 3B2 (36445-71-3) | anionic |
| 13 | Benzene, 1,1'-oxybis-, tetrapropylene derivs., sulfonated, sodium salts | DOWFAX^{®} 2A1 (119345-04-9) | anionic |
| 14 | Disodium hexadecyldiphenyloxide disulfonate | DOWFAX^{®} 8390 TSF-20 (65143-89-7) | anionic |
| 15 | Poly(styrene sulfonic acid), M.W. 75,000 | PSS 75K (28210-41-5) | anionic |
| 16 | (C10-C16)alkyl benzene sulfonic acid , DBS | (68584-22-5) | anionic |
| 17 | poly(2-acrylamido-2-methyl-1-propanesulfonic acid) | ALCOSPERSE^{®} 510 | anionic |
| 18 | 2, 4, 7, 9-Tetramethyldec-5-yne-4, 7-diol | OLFINE WE-001 | anionic |
| 19 | 2, 4, 7, 9-Tetramethyldec-5-yne-4, 7-diol | OLFINE^{®} WE-003 | anionic |
| 20 | 3, 5-Dimethlyhex-1-yne-3-ol | SURFYNOL^{®} S61 | non-ionic |
| 21 | 2,4,7, 9-Tetramethyldodec-5-yne-4, 7-diol ethoxylated with 3.5 moles of EO per mole of diol | SURFYNOL^{®} 440 | non-ionic |
| 22 | 2, 4, 7, 9-Tetramethyldec-5-yne-4, 7-diol ethoxylated with 30 moles of EO per mole of diol | SURFYNOL^{®} 485 | non-ionic |
| 23 | 2, 5,8, 11-Tetramethyldodec-6-yne-5, 8-diol ethoxylated with 4 moles of EO per mole of diol | SURFYNOL^{®} 604 | non-ionic |
| 24 | P.O.E styrenated aryl ether phosphate | SINONATE^{®} 707P | anionic |
| 25 | 2-(2-Nonylphenoxy)ethanol -phosphoric acid (1:1) | SINOPOL^{®} 9620P | non-ionic |
| 26 | Polyoxyethylene tridecyl ether phosphate | RHODAFAC^{®} RS710 (9046-01-9) | anionic |
| 27 | Polyoxyethylene alkyl ether carboxylate | SINONATE^{®} 1307CA | Anionic |
| 28 | (1-dodecylpyridinium chloride hydrate) | | Cationic |
| 29 | Hexadecyltrimethylammonium bromide | | Cationic |
| 30 | Alco4773 (35.52%) | | Cationic |
| 31 | poly-(diallyldimethyl ammonium chloride), 35%, average Mw <100,000 | | Cationic |
| 32 | poly(dimethylamine-co-epichlorohydrin-co-ethylenediamine) (PDEE), 50%, average Mw ~75,000 | | Cationic |
| 33 | poly(acrylamide-co-diallydimethyl ammonium chloride) (PAAM-DADMAC), 10% | | Cationic |
| 34 | poly(acrylamide) (PAM) | | Cationic |
| 35 | Cetyl trimethyl ammonium chloride (average Mw ~10,000) | | Cationic |

| | | | |
|---|---|---|---|
| * In Table 2: CAS = Chemical Abstracts Service accession number of active component. | | | |

The SURFYNOL and ZETASPERSE brand surfactants are available from Air Products and Chemicals, Inc.; the SINOPOL and SINONATE brand surfactants are available from Sino-Japan Chemical Co., Ltd.; the OLFINE brand surfactants are available from Shin-Etsu Chemical Co.; the RHODAFAC brand surfactants are available from Rhodia; the ADEKA brand surfactants are available from Adeka Corp., the DOWFAX brand surfactants are available from Dow Chemical Co; and the ALCOSPERSE brand surfactants are available from AkzoNobel Surface Chemistry, LLC.

### EXAMPLE 2

This example illustrates the effects of ferric ion as oxidizing agent on TiN RR for CMP compositions comprising various surfactants. This example is not forming part of the invention.

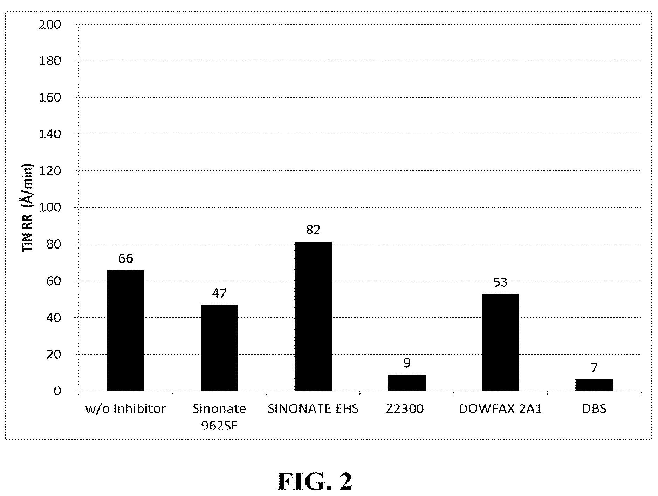

Aqueous CMP compositions having a pH of 2.3 and comprising 0.025 percent by weight (wt%) of colloidal silica (abrasive J from Table 1, Fuso Chemical Co. Ltd.), 750 ppm of ferric nitrate, and 0.162 wt% of malonic acid, additionally containing various surfactants at 1000 ppm (on an active concentration basis) were prepared. TiN blanket wafers were polished with a polishing pad (Fujibo) and the CMP compositions, for 60 seconds using the following polishing parameters. Carrier speed of 111rpm, platen speed of 113 rpm, down force of 1.5 psi and slurry flow rate of 150 ml. FIG. 2 provides graphs of the TiN removal rates for the various compositions, compared to a similar composition without a surfactant inhibitor.

The results in FIG. 2 show that the lowest TiN removal rates, i.e. highest TiN RR suppression, were obtained with dodecylbenzene sulfonic acid (DBS) and a mixture of (C10-C14) alkylbenzene sulfonate and ethoxylated (C6-C12) alcohols (ZETASPERSE 2300), both of which are alkylbenzene sulfonate surfactants.

### EXAMPLE 3

This example illustrates the effects of abrasive solids concentration on TiN RR suppression for CMP compositions comprising a colloidal silica abrasive with and without dodecylbenzene sulfonic acid (DBS) surfactant. This example is not forming part of the invention.

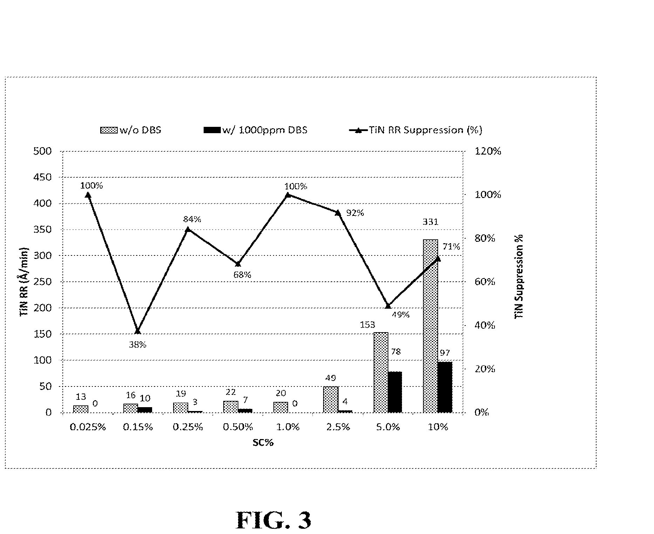

Aqueous polishing slurries comprising a colloidal silica abrasive (Abrasive J from Table 1, Fuso Chemical Co.) and 0.5 wt% hydrogen peroxide at pH 2.3, with and without 1000 ppm DBS, were prepared at various abrasive solids concentrations (SC%) and evaluated by polishing TiN blanket wafers for 60 seconds using a Fujibo H7000 polishing pad and the following polishing parameters: carrier speed of 111 rpm, platen speed of 113 rpm, down force of 1.5 psi and slurry flow rate of 150 mL. The polishing results are shown graphically in FIG. 3.

The data in FIG. 3 indicate that the TiN RR suppression was distributed somewhat variably in the range of 38% to 100 % over a solids concentration range of 0.025 wt% to 10 wt%, with the TiN RR remaining below 50 Å/min up to a solids concentration of 2.5 wt% under the polishing conditions utilized in this evaluation. Additionally, the results indicate that even at high solids concentration (10%), which resulted in higher polishing rates, the TiN RR suppression was still high (71%).

### EXAMPLE 4

This example illustrates the effect of pH on TiN RR suppression for CMP compositions comprising a colloidal silica abrasive with and without dodecylbenzene sulfonic acid (DBS) surfactant. This example is not forming part of the invention.

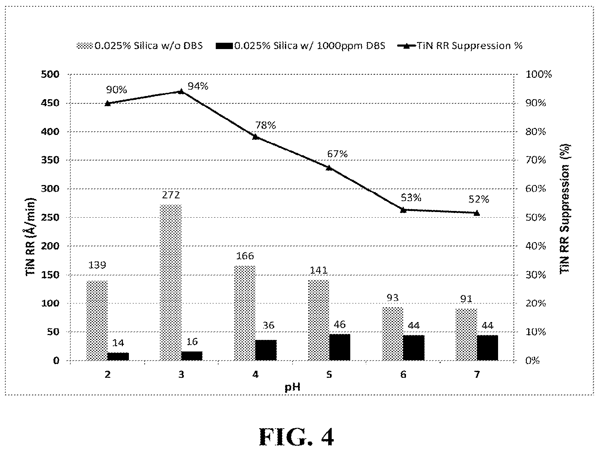

Aqueous polishing slurries comprising a colloidal silica abrasive (Abrasive J from Table 1, Fuso Chemical Co. Ltd.) and 0.5 wt% hydrogen peroxide at pH 2.3, with and without 1000 ppm of DBS, were prepared at integral pH values from 2 to 7. The CMP compositions were evaluated by polishing TiN blanket wafers for 60 seconds using the following polishing parameters: Fujibo H7000 polishing pad, carrier speed of 111 rpm, platen speed of 113 rpm, down force of 1.5psi and slurry flow rate of 150mL. The polishing results are shown graphically in FIG. 4.

The results in FIG. 4 indicate that the highest TiN RR suppression levels were attained at pH 2 and 3.

### EXAMPLE 5

This example illustrates the effect of different abrasive materials on TiN RR suppression for CMP compositions with and without dodecylbenzene sulfonic acid (DBS) surfactant. This example is not forming part of the invention.

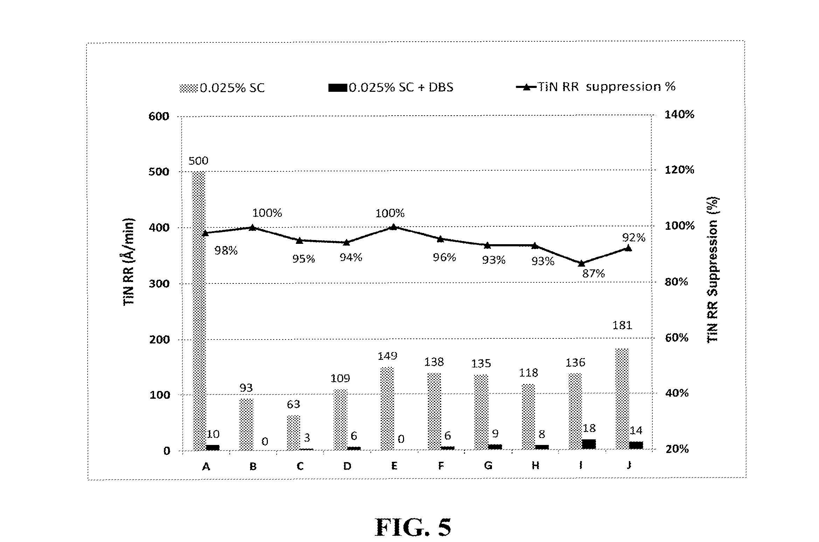

Aqueous polishing slurries comprising the 0.025 wt% of the abrasives listed in Table 1, and 0.5 wt% hydrogen peroxide at pH 2.3, with and without 1000 ppm of DBS, were prepared. The CMP compositions were evaluated by polishing TiN and W blanket wafers for 60 seconds using the following polishing parameters: Fujibo H7000 polishing pad, carrier speed of 111 rpm, platen speed of 113 rpm, down force of 1.5 psi and slurry flow rate of 150 mL. The TiN polishing results are shown graphically in FIG. 5.

The results in FIG. 5 indicate that all of the tested abrasives showed very high TiN RR Suppression with actual TiN RR values below 20 Å/min under the evaluation conditions, for the treatments having a surfactant. The results also indicate that the TiN RR for treatments not having a surfactant varied widely, for example, from 500 to 63 Å/min.

The use of the terms "a" and "an" and "the" and similar referents in the context of describing the invention (especially in the context of the following claims) are to be construed to cover both the singular and the plural, unless otherwise indicated herein or clearly contradicted by context. The terms "comprising," "having," "including," and "containing" are to be construed as open-ended terms (i.e., meaning "including, but not limited to,") unless otherwise noted. The terms "consisting of" and "consists of" are to be construed as closed terms, which limit any compositions or methods to the specified components or steps, respectively, that are listed in a given claim or portion of the specification. In addition, and because of its open nature, the term "comprising" broadly encompasses compositions and methods that "consist essentially of" or "consist of" specified components or steps, in addition to compositions and methods that include other components or steps beyond those listed in the given claim or portion of the specification. Recitation of ranges of values herein are merely intended to serve as a shorthand method of referring individually to each separate value falling within the range, unless otherwise indicated herein, and each separate value is incorporated into the specification as if it were individually recited herein. All numerical values obtained by measurement (e.g., weight, concentration, physical dimensions, removal rates, flow rates, and the like) are not to be construed as absolutely precise numbers, and should be considered to encompass values within the known limits of the measurement techniques commonly used in the art, regardless of whether or not the term "about" is explicitly stated. All methods described herein can be performed in any suitable order unless otherwise indicated herein or otherwise clearly contradicted by context. The use of any and all examples, or exemplary language (e.g., "such as") provided herein, is intended merely to better illuminate certain aspects of the invention and does not pose a limitation on the scope of the invention unless otherwise claimed. No language in the specification should be construed as indicating any non-claimed element as essential to the practice of the invention.

Preferred embodiments of this invention are described herein, including the best mode known to the inventors for carrying out the invention.

## Claims

1. A chemical mechanical polishing (CMP) method of polishing a substrate comprising a metal deposited over a titanium nitride (TiN) barrier layer; the method comprising contacting the substrate with an acidic CMP composition comprising a particulate abrasive suspended in a liquid carrier, wherein the particulate abrasive comprises colloidal silica and has a mean particle size of 10 to 150 nm, the liquid carrier comprising a surfactant, wherein the surfactant comprises a mixture of C10-C14 alkylbenzene sulfonate and ethoxylated C6-C12 alcohols, wherein the surfactant suppresses a rate at which the TiN is polished, wherein pH of the CMP composition is in the range of 2 to 5, and wherein the CMP composition further comprises hydrogen peroxide in a range of 0.01 to 5 wt%.

2. The method of claim 1 wherein the particulate abrasive is present in the CMP composition at a concentration of 0.001 to 10 percent by weight (wt%).

3. The method of claim 1 wherein the surfactant is present in the CMP composition at a concentration in the range of 10 to 50,000 parts-per-million (ppm).

4. The method of claim 1 wherein the abrading is accomplished in conjunction with a polishing pad in a CMP polishing apparatus.

## Patentansprüche

1. Verfahren zum chemisch-mechanischen Polieren (CMP) eines Substrats, das ein auf einer Titannitrid (TiN)-Sperrschicht abgeschiedenes Metall umfasst; wobei das Verfahren das Inkontaktbringen des Substrats mit einer sauren CMP-Zusammensetzung umfasst, die ein in einem flüssigen Träger suspendiertes partikuläres Schleifmittel umfasst, wobei das partikuläre Schleifmittel kolloidales Siliziumdioxid umfasst und eine mittlere Partikelgröße von 10 bis 150 nm aufweist, wobei der flüssige Träger ein Tensid umfasst, wobei das Tensid eine Mischung aus C10-C14-Alkylbenzolsulfonat und ethoxylierten C6-C12-Alkohole, wobei das Tensid die Polierrate des TiN unterdrückt, wobei der pH-Wert der CMP-Zusammensetzung im Bereich von 2 bis 5 liegt und wobei die CMP-Zusammensetzung ferner Wasserstoffperoxid in einem Bereich von 0,01 bis 5 Gew.-% umfasst.

2. Verfahren nach Anspruch 1, wobei das partikuläre Schleifmittel in der CMP-Zusammensetzung in einer Konzentration von 0,001 bis 10 Gewichtsprozent (Gew.-%) vorliegt.

3. Verfahren nach Anspruch 1, wobei das Tensid in der CMP-Zusammensetzung in einer Konzentration im Bereich von 10 bis 50.000 parts-per-million (ppm) vorliegt.

4. Verfahren nach Anspruch 1, wobei das Abschleifen in Verbindung mit einem Polierpad in einer CMP-Poliervorrichtung erfolgt.

## Revendications

1. Procédé de polissage chimico-mécanique (CMP) destiné à polir un substrat comprenant un métal déposé sur une couche barrière de nitrure de titane (TiN) ; le procédé comprenant la mise en contact du substrat avec une composition d'acide CMP comprenant un abrasif particulaire en suspension dans un véhicule liquide, dans lequel l'abrasif particulaire comprend de la silice colloïdale et a une taille moyenne de particules de 10 à 150 nm, le véhicule liquide comprenant un tensioactif, dans lequel le tensioactif comprend un mélange d'alkylbenzènesulfonates en C10-C14 et d'alcools éthoxylés en C6-C12, dans lequel l'agent tensioactif réduit la vitesse de polissage du TiN, dans lequel le pH de la composition CMP est dans la plage de 2 et 5, et dans lequel la composition CMP comprend en outre du peroxyde d'hydrogène dans une plage de 0,01 à 5 % en poids.

2. Procédé selon la revendication 1, dans lequel l'abrasif particulaire est présent dans la composition CMP à une concentration de 0,001 à 10 pour cent en poids (% p/p).

3. Procédé selon la revendication 1, dans lequel l'agent tensioactif est présent dans la composition CMP à une concentration dans la plage de 10 à 50 000 parties par million (ppm).

4. Procédé selon la revendication 1, dans lequel l'abrasion est réalisée conjointement avec un tampon de polissage dans un appareil de polissage CMP.
